# EUROPEAN PATENT APPLICATION

(11) **EP 4 654 749 A1**
(43) Date of publication of application: **26.11.2025**
(21) Application number: 25177309.9
(22) Date of filing: 19.05.2025
(51) Int. Cl.: H05B 6/06, H05K 1/14, H05B 6/12

(54) **MODULAR CIRCUIT BOARD FOR INDUCTION COOKING**

(30) Priority: 22.05.2024 US 202418670826
(71) Applicant: Whirlpool Corporation, Benton Harbor, MI 49022 (US)
(72) Inventor: BARBATI, Mario, c/o WHIRLPOOL CORPORATION, 2000 NORTH M-63, BENTON HARBOR, MI, 49022 (US); GALLIVANONI, Andrea, c/o WHIRLPOOL CORPORATION, 2000 NORTH M-63, BENTON HARBOR, MI, 49022 (US); BALDO. Salvatore, c/o WHIRLPOOL CORPORATION, 2000 NORTH M-63, BENTON HARBOR, MI, 49022 (US)
(74) Representative: Eisenführ Speiser

(57) **Abstract**

A circuit apparatus for an induction cooktop (10) including at least one induction coil (14). At least one first circuit board (16) extends along a first plane. At least one second circuit board (18) extends along a second plane and is rigidly connected with the at least one first circuit board (16). Power circuitry is disposed on the at least one first circuit board (16) and is configured to supply power to the at least one induction coil (14). Switching circuitry (22) is disposed on the at least one second circuit board (18) and is electrically interposing the power and control circuit (20) and the at least one induction coil (14). The switching circuitry supplies a drive signal (S_{D}) to the at least one induction coil (14). A control circuit (20) is disposed on the at least one first circuit board (16) and is configured to control the switching circuitry.

## Description

### BACKGROUND OF THE DISCLOSURE

The present disclosure generally relates to a modular printed circuit board assembly, and more specifically, to a printed circuit board for induction cooking.

### SUMMARY OF THE DISCLOSURE

According to one aspect of the present disclosure, an induction cooktop includes an induction coil. A first circuit board extends along a first plane. A second circuit board extends along a second plane and is rigidly connected with the first circuit board. Power circuitry is disposed on the first circuit board and is configured to supply power to the induction coil. A control circuit is disposed on the first circuit board. Switching circuitry is disposed on the second circuit board and is electrically interposing the power and control circuitry and the induction coil. The switching circuitry supplies a drive signal to the induction coil.

According to another aspect of the present disclosure, a method of manufacturing an induction cooktop includes providing an induction coil. Providing a control circuit disposed on a first circuit board. Providing switching circuitry disposed on a second circuit board. Outputting a control signal from the control circuit to the switching circuitry via the first circuit board. Outputting a drive signal from the switching circuitry. Conducting the drive signals from the second circuit board to the induction coil.

According to yet another aspect of the present disclosure, an induction cooktop includes an induction coil. Power circuitry is disposed on a first circuit board. Switching circuitry is disposed on a second circuit board. A control circuit is disposed on the first circuit board, where the control circuit outputs a control signal to the switching circuitry.

These and other features, advantages, and objects of the present disclosure will be further understood and appreciated by those skilled in the art by reference to the following specification, claims, and appended drawings.

### BRIEF DESCRIPTION OF THE DRAWINGS

In the drawings:
FIG. 1 is a side perspective of an induction cooktop incorporating one or more induction coils according to one aspect of the present disclosure;
FIG. 2A is a block diagram of a circuit apparatus for an induction cooktop constructed according to at least one aspect of the present disclosure;
FIG. 2B is an electrical schematic of a circuit apparatus for an induction cooktop constructed according to at least one aspect of the present disclosure;
FIG. 3A is a side perspective view of a first circuit board according to one aspect of the present disclosure;
FIG. 3B is a side perspective view of a second circuit board including a heatsink according to one aspect of the present disclosure;
FIG. 4A is a cross-sectional view of a first or second circuit board including a metallic layer according to one aspect of the present disclosure;
FIG. 4B is a cross-sectional view of a first or second circuit board including a thermal insulation layer according to one aspect of the present disclosure;
FIG. 5A is a side perspective view of a second circuit board rigidly connected to a first circuit board according to one aspect of the present disclosure;
FIG. 5B is a side plan view of a second circuit board including a heatsink, and rigidly connected to a first circuit board according to one aspect of the present disclosure;
FIG. 6A is a side perspective view of a second circuit board rigidly connected to a first circuit board and extending horizontally from a second edge of the first circuit board according to one aspect of the present disclosure;
FIG. 6B is a side plan view of a second circuit board rigidly connected to a first circuit board and extending horizontally from a second edge of the first circuit board according to one aspect of the present disclosure;
FIG. 7A is a side perspective view of a second circuit board rigidly connected to a first circuit board, the second circuit board including a heatsink extending upward relative to a first side of the first circuit board according to one aspect of the present disclosure;
FIG. 7B is a front plan view of a second circuit board rigidly connected to a first circuit board, the second circuit board including a heatsink extending upward relative to a first side of the first circuit board according to one aspect of the present disclosure;
FIG. 8A is side perspective view of a second circuit board including switching circuitry rigidly connected to a first side of a first circuit board according to one aspect of the present disclosure; and
FIG. 8B is a bottom perspective view of a second circuit board including switching circuitry rigidly connected to a first side of a first circuit board according to one aspect of the present disclosure.

The components in the figures are not necessarily to scale, emphasis instead being placed upon illustrating the principles described herein.

### DETAILED DESCRIPTION

The present illustrated embodiments reside primarily in combinations of method steps and apparatus components related to a modular circuit board for induction cooking. Accordingly, the apparatus components and method steps have been represented, where appropriate, by conventional symbols in the drawings, showing only those specific details that are pertinent to understanding the embodiments of the present disclosure so as not to obscure the disclosure with details that will be readily apparent to those of ordinary skill in the art having the benefit of the description herein. Further, like numerals in the description and drawings represent like elements.

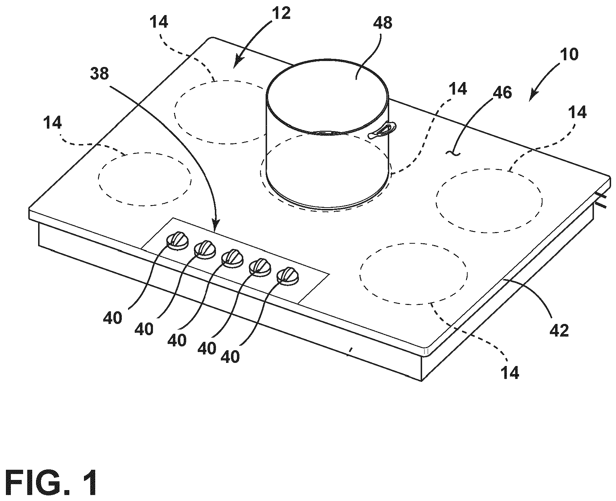

For purposes of description herein, the terms "upper," "lower," "right," "left," "rear," "front," "vertical," "horizontal," and derivatives thereof shall relate to the disclosure as oriented in FIG. 1. Unless stated otherwise, the term "front" shall refer to the surface of the element closer to an intended viewer, and the term "rear" shall refer to the surface of the element further from the intended viewer. However, it is to be understood that the disclosure may assume various alternative orientations, except where expressly specified to the contrary. It is also to be understood that the specific devices and processes illustrated in the attached drawings, and described in the following specification are simply exemplary embodiments of the inventive concepts defined in the appended claims. Hence, specific dimensions and other physical characteristics relating to the embodiments disclosed herein are not to be considered as limiting, unless the claims expressly state otherwise.

The terms "including," "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element proceeded by "comprises a . . . " does not, without more constraints, preclude the existence of additional identical elements in the process, method, article, or apparatus that comprises the element.

In general, the present induction cooktop provides an induction coil circuitry that may be cost-effective and electrically efficient, as described herein.

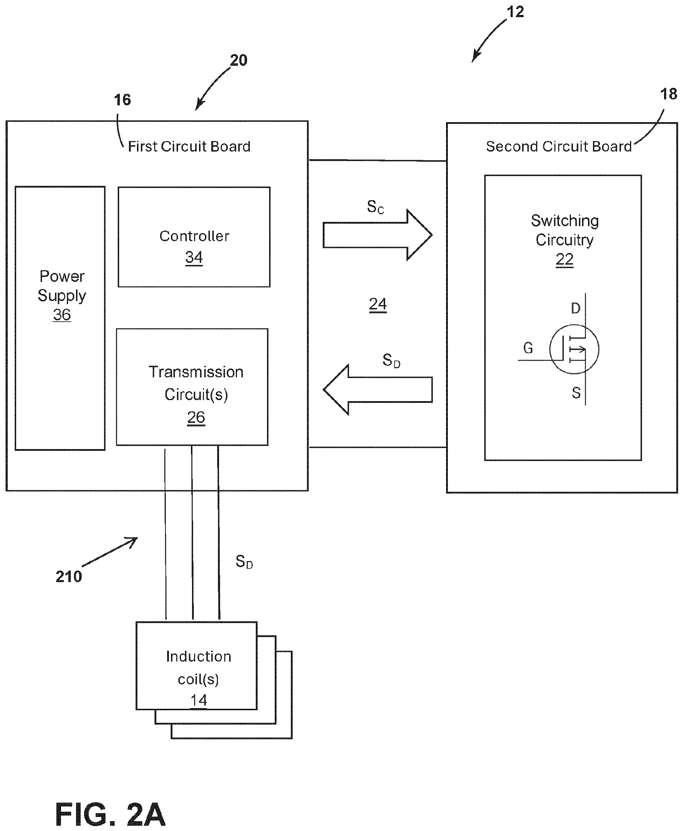

Referring generally to FIGS. 1 and 2A, numeral 10 generally designates an induction cooktop. The induction cooktop 10 may include a circuit apparatus 12. The circuit apparatus 12 may comprise an induction coil 14, supplied with control signals S_{c} and drive signals S_{D} from a first circuit board 16 and a second circuit board 18. In operation, control signals S_{c} may be generated by a control circuit 20 disposed on the first circuit board 16. The control signals S_{c} may be conducted via the first circuit board 16 to switching circuitry 22 disposed on the second circuit board 18. The control signals S_{c} may then be converted by the switching circuitry 22 to drive signals S_{D} for the induction coil 14 and conducted back from the second circuit board 18 to the first circuit board 16 via a connection interface 24. The drive signals S_{D} may then be conducted to the induction coil 14 via a transmission circuit 26 disposed on the first circuit board 16.

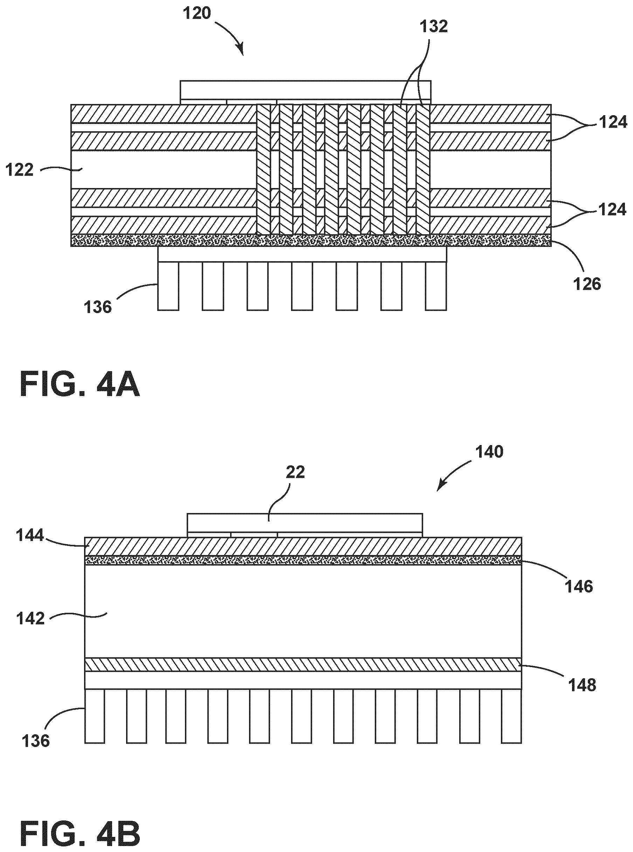

In operation, the high frequency switching of the switching circuitry 22 may generate heat that may need to be managed by effectively dissipating heat energy away from the switching circuitry 22. Accordingly, the second circuit board 18 may be formed from one or more thermally conductive materials to promote heat dissipation away from the switching circuitry 22. The high thermal resistance between the second circuit board 18 relative to the first circuit board 16 of the disclosure may provide for improved operation and modular packaging to suit a variety of applications. Exemplary structures and materials for the first circuit board 16 and the second circuit board 18 are described in further detail in FIGS. 4A and 4B.

In various implementations, the control circuit 20 may comprise a controller 34 and power supply 36, each of which may be positioned on the first circuit board 16. The power supply 36 may deliver operating current to the controller 34 via the first circuit board 16 and may further supply current to the switching circuitry 22 on the second circuit board 18 via the connection interface 24. In operation, the control signals S_{c} from the controller 34 may be supplied to the switching circuitry 22, which may result in the generation of heat. However, the low thermal resistance of the second circuit board 18 relative to the first circuit board 16 and the positioning of the switching circuitry 22 on the second circuit board 18, separate from the power supply 36, the controller 34, and other circuits on the first circuit board 16 may protect the components on the first circuit board 16 from thermal damage. Accordingly, the low thermal resistance of the second circuit board 18 in relation to the first circuit board 16, assists in dissipating waste heat generated by the switching circuitry 22. To support operation of the induction cooktop 10 in this configuration, the disclosure may further provide for corresponding material and structural configurations of each of the circuit boards 16, 18 based on the competing requirements of economical design and heat management.

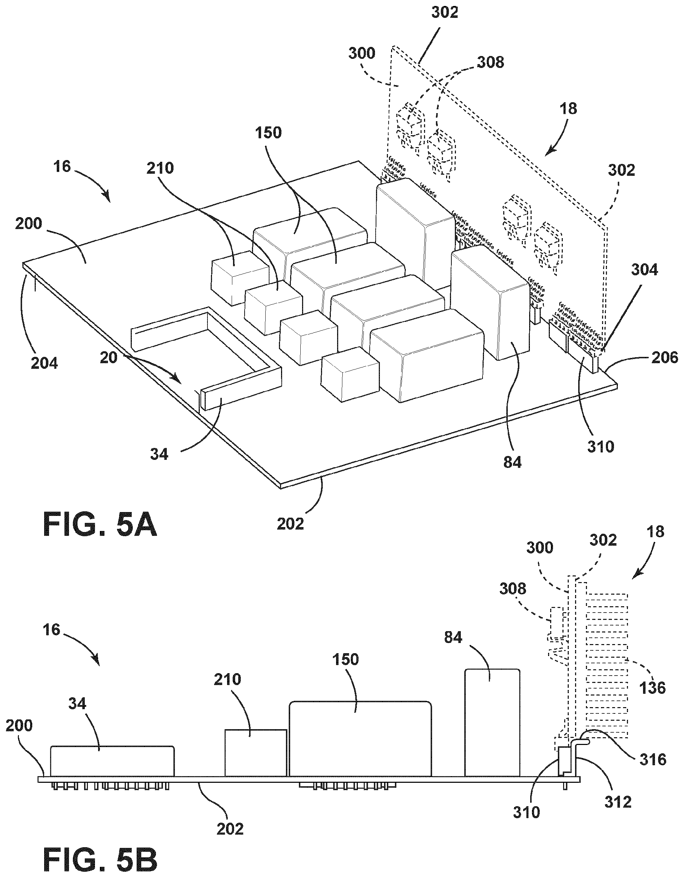

As demonstrated in various examples shown in FIGS. 5-8, the first circuit board 16 and the second circuit board 18 may be arranged in various spatial configurations or orientations for utilization in various applications. In each of the configurations later discussed, the switching circuitry 22 of the second circuit board 18 may be conductively positioned between the controller 34 and the induction coil(s) 14. In this configuration, the control signals S_{c} may be communicated from the first circuit board 16 to the second circuit board 18, respectively. The induction coil 14 connected to the first circuit board 16 may provide for improved thermal management through the high thermal resistance of the first circuit board 16 from the second circuit board 18. Through this high thermal resistance, the second circuit board 18 may incorporate design features to promote heat dissipation, as further described herein.

Referring now to FIG. 1, the induction cooktop 10 may include an induction hob and can include a control interface 38 which may include mechanical switches 40 and/or touch interfaces for controlling the induction cooktop 10. For example, a controller 34 of the control circuit 20 may be provided within the induction cooktop 10 for controlling power to one or more of an induction coil 14 of the induction cooktop 10. A glass layer 42, or insulating layer, may form a cooking surface 46 for cookware 48, and may provide space between the induction coils 14 in the induction cooktop 10 and the cooking surface 46. It is contemplated that, while shown in FIG. 1 as having a circular shape, one or more of the induction coils 14 may have another polygonal or arcuate shape, such as a square, rectangle, triangle, or the like. It is also contemplated that irregular polygonal shapes or partial rectangular shapes (e.g., rectangles with arcuate corners) may be provided. Accordingly, the induction cooktop 10 may incorporate one or more differently shaped induction coils 14. Further, the spacing and/or pattern of distribution of the induction coils 14 for the induction cooktop 10 may be different than pictured or the same as pictured. For example, the induction coils 14 may be arranged side to side or front to back to provide a free-form induction cooking area throughout the entire cooking surface 46 or a substantial part of the cooking surface 46. Further, different sizes of the induction coils 14 may be provided.

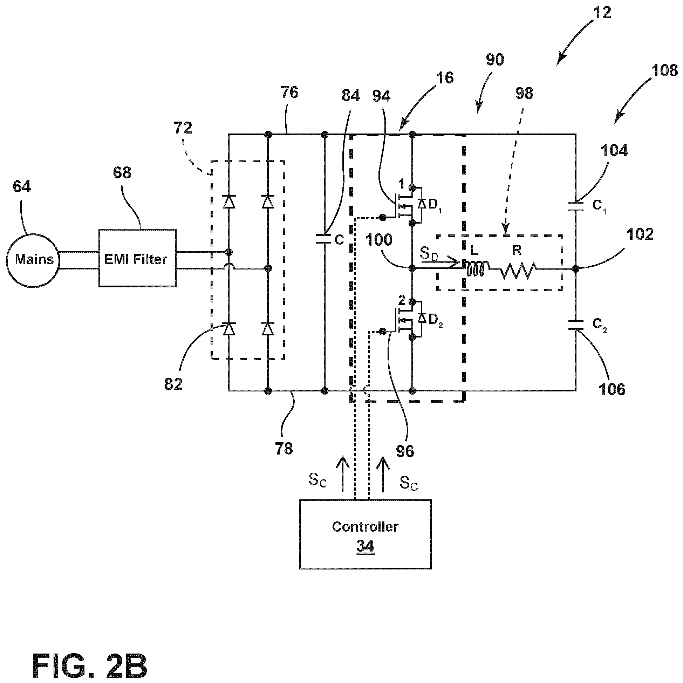

To clearly describe the benefits of the circuit apparatus 12 of the disclosure, the operation of the induction cooktop 10 is now described in reference to an exemplary circuit shown in FIG. 2B. Referring now to FIG. 2B, the circuit apparatus 12 is demonstrated in reference to a single induction coil 14. Though demonstrated in reference to a single induction coil 14, it shall be understood that the circuit apparatus 12 may supply drive signals S_{D} to a plurality of induction coils 14. For example, the circuit apparatus 12 may be configured to power some or all of the induction coils 14 of the induction cooktop 10. The circuit apparatus 12 may be powered via mains power 64, which may be an alternating-current (AC) voltage. For example, the main power 64 may include 110VAC/115VAC, 120VAC, 230VAC/240VAC with a frequency of 50Hz/60Hz, or another AC signal typically provided for residential or commercial power distribution. An electromagnetic interference (EMI) filter 68 is provided for reducing electromagnetic interference generated during high-frequency operation of the induction cooktop 10. The EMI filter 68 typically includes capacitors and inductors arranged to suppress unwanted electromagnetic radiation.

The filtered power is provided to a rectifier 72 that converts alternating current power to direct current (DC) power provided along a DC bus 76 and a ground 78. For example, the rectifier 72 can include one or more diodes 82 arranged to isolate positive parts of the AC power, and one or more smoothing capacitors, such as a DC bus capacitor 84, to smooth the DC power. One or more inverters 90 are provided between the DC bus 76 and ground 78 for generating controlled AC signals through one or more of the induction coils 14. In the present example, a half-bridge inverter 90 is provided for controlling each induction coil 14, though, it is contemplated that other types of inverters 90 (e.g., full bridge inverters, quasi-resonant inverters, and so on) may be provided in some examples described herein. In some implementations, a full-bridge inverter 90 is used to allow for operation at higher effective AC voltages relative to those used for a half-bridge, thereby allowing for reduced operating currents for the same power levels.

In general, each inverter 90 includes one or more switches 94, 96 such as transistors, that are controlled by the controller 34 to close and/or open paths for current to flow through the induction coil 14 and the cookware 48. In the half-bridge example of FIG. 2B, the induction coil 14 and the cookware 48 are represented by the equivalent electrical model 98 and may be connected between two intermediate nodes 100, 102 that are electrically coupled to the corresponding switches 94, 96 and a pair of corresponding capacitors 104, 106 forming a resonant circuit 108. The two intermediate nodes 100, 102 include a first intermediate node 100 that electrically interposes a first switch and a second switch 94, 96 and a second intermediate node 102 that interposes a pair of capacitors 104, 106. In operation, the controller 34 energizes the first switch 94 at a first time, then de-energizes the first switch 94, then energizes the second switch 96, then de-energizes the second switch 96, and so on. In this way, the inverter 90 is controlled to provide an effective AC voltage across the resonant circuit 108 to generate magnetic fields through the insulating layer of the induction cooktop 10. For example, when alternating currents pass through the induction coil 14, a magnetic field is generated. When cookware 48 is positioned over the induction coils 14, the induced magnetic fields can cause Eddy currents in the cookware 48, thereby heating the cookware 48.

As best illustrated in the example shown in FIG. 2B, the elements of the circuit apparatus 12 forming the switching circuitry 22 may primarily include the first switch 94 and the second switch 96. As shown in the typical circuit topography illustrated, the switches 94, 96 forming the switching circuitry 22 are conductively positioned central to the operation of the circuit apparatus 12 because they receive the control signals S_{c} from the controller 34 and output the drive signals S_{D} to the induction coil(s) 14. Accordingly, the mechanical isolation of the second circuit board 18 from the first circuit board 16 may be counterintuitive. However, as provided by the disclosure, the structure of the second board 18 to thermally manage the heat generated by the switching circuitry 22 may provide various benefits. For example, the separate assemblies of the first circuit board 16 and the second circuit board 18 may provide for improved flexibility by allowing for modular designs as shown in FIGS. 5-8. Further, each of the circuit boards 16, 18 may be constructed of different material and configurations to support the different operating requirements as demonstrated in FIGS. 4A and 4B.

Referring again to FIG. 2B, it is contemplated that the resonant circuit 108 may be dependent on the type of cookware 48 (e.g., material, size, shape, etc.). For example, the representation of the equivalent electrical model 98 may include resistance when the cookware 48 is provided. By way of example, the cookware 48 may include stainless steel in a bottom portion of the cookware 48 (e.g., a floor of a pan or a pot). In general, the cookware may be composed of ferritic stainless steel, which is characterized by a high chromium content and low carbon content. The AISI 430 stainless steel has strong corrosion resistance, formability, and heat resistance. For example, AISI 430 can contain between approximately 16% and approximately 18% Chromium, low Carbon, and a remainder of iron. AISI 430 is generally magnetic.

According to one aspect of the present disclosure, the induction coil 14 and the cookware 48 are represented by the equivalent electrical model 98, with the equivalent AC resistance between approximately 2 ohms and approximately 15 ohms at the working frequency when the cookware 48 overlays the induction coil 14 and the bottom portion is made of AISI 430. The inductance of the induction coil 14 may be between 40 micro-Henries (uH) and 70 uH when the equivalent resistance is between approximately 2 ohms and approximately 15 ohms at the working frequency. Other ranges of resistance and/or inductance may be achieved according to various examples described herein.

Referring generally now to FIGS. 2A and 2B, the one or more switches 94, 96 of the switching circuitry 22 may correspond to power transistors. The specific type of device used for the switches 94, 96 of the switching circuitry 22 may include, but is not limited to, metal-oxide-semiconductor field-effect transistors (MOSFETs), insulated-gate bipolar transistors (IGBTs), solid state switches, power distribution switches, load drivers, and so on. Additionally, the choice of the specific type of device used for the controller 34 of the control circuit 20 may include, but is not limited to, a digital signal processor, a microprocessor, a microcontroller, logic circuitry, application-specific integrated circuit, and analog circuitry to generate the appropriate signals.

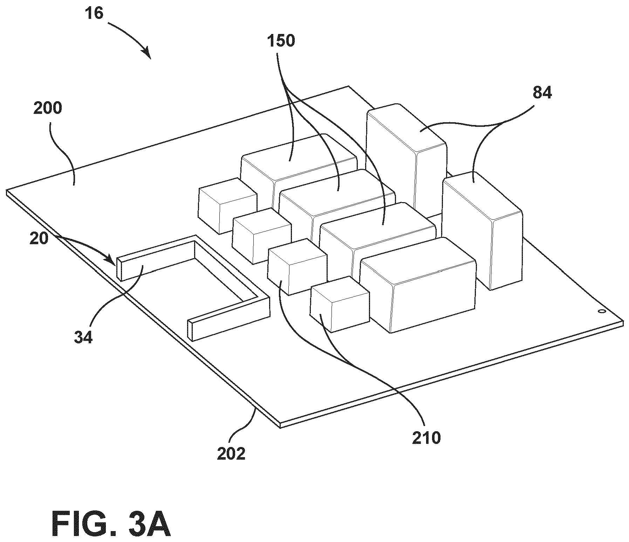

Referring now to FIGS. 3A-4B, a printed circuit board assembly of the induction cooktop 10 may include the first circuit board 16 which may be electrically connected to various devices, as is further described herein. The printed circuit board assembly of the induction cooktop 10 may also include the second circuit board 18. The second circuit board 18 may be rigidly connected to the first circuit board 16, and electrically connected to the induction coils 14. The first circuit board 16 and the second circuit board 18 may be constructed from a varying class of printed circuit boards, as further described herein.

Referring to FIGS. 3A and 4A, construction of the first circuit board 16 or the second circuit board 18 may be designed to assist in maintaining efficient electrical and thermal conductivity. Thermal conductivity defines the quantity of heat transmitted through a unit thickness of a material, per unit area, per unit time, and per unit temperature gradient. Accordingly, as thermal conductivity of the material increases the heat conduction of the material is improved. In some implementations, the first circuit board 16 or the second circuit board 18 may be constructed from a thermally insulated board 120, using an FR4 substrate that may generally consist of a fiberglass, or other similar insulative, nonconductive substrate base 122 overlaid with one or more conductive layers 124. For example, the first circuit board 16 may include a thermal conductivity of between approximately 0.1 W/mK and between approximately 0.9 W/mK, or may be between approximately 0.1 W/mK and between approximately 0.5 W/mK, or may be between approximately 0.15 W/mK and between approximately 0.35 W/mK. In some implementations, the thermal conductivity of the FR4 board may be between approximately 0.2 W/mK and between approximately 0.4 W/mK. Accordingly, the first circuit board 16 may include a thermal conductivity of less than 1 W/mK. As used herein, the term approximately when referring to a value or range of values is meant to encompass variations of +/- 10% from the specified value.

One of the conductive layers 124 may include printed conductive traces that may generally define patterned metallic interconnections carrying electrical signals between components mounted on the board 120. Accordingly, the conductive layer 124 of the second circuit board 18 may allow for higher functional integration and improved signal integrity of the control signal S_{C} from the first circuit board 16 to the switching circuitry 22 of the second circuit board 18. The conductive layers 124 may further increase component density and allow for a more efficient use of the second circuit board 18. Accordingly, the exemplary implementations of the arrangement and number of conductive layers 124 may be contemplated.

A number of through-hole vias 132 may extend between opposing sides of the board 120 to connect traces of different layers of the board 120. Being generally composed of (or coated with) copper, the through-hole vias 132 may also have thermal conduction properties that may provide thermal contact between the layers of the board 120. One of the opposing sides of the board 120 may interface with a heatsink 136 via the thermal conductivity layer 126. The thermal conductivity layer 126 may be positioned between the heatsink 136 and the conductive layer 124. Accordingly, one of the opposing sides of the board 120 may include surface mounted devices, such as the switching circuitry 22, soldered or attached to the board 120, and the corresponding opposing side may include the heatsink 136. Further, in some implementations, the first circuit board 16 or the second circuit board 18 may be of a varying class of printed circuit boards that may define electric and thermal conductive properties, such as polymer-based printed circuit boards including, but not limited to FR-4 circuit boards, Composite Epoxy Material (CEM) printed circuit boards, and polyimide (PI) boards.

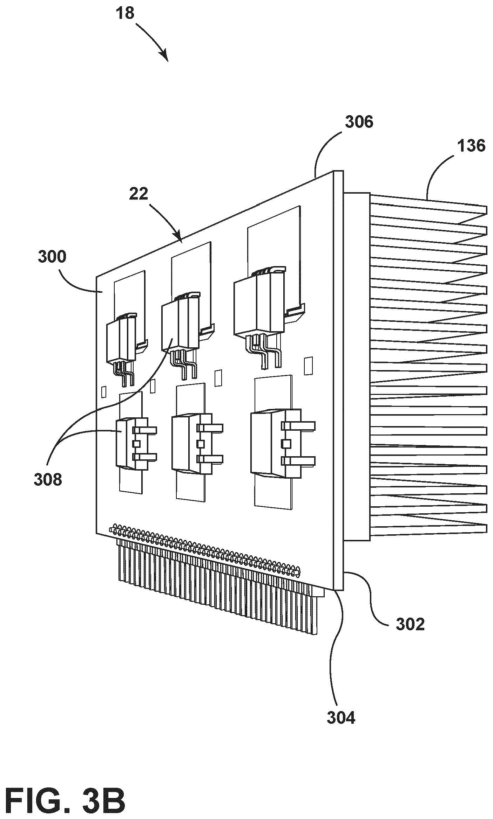

Referring now to FIGS. 3B and 4B, the second circuit board 18 assists in the dissipation of significant amounts of heat generated during operation, as opposed to signal transmission of the first circuit board 16. For example, the second circuit board 18 may consist of a metallic board 140 that may include a metallic base 142, such as an aluminum substrate base, that readily conducts heat, for example, an IMS (insulated metal substrate) board. For example, the second circuit board 18 may include a thermal conductivity of between approximately 1 W/mK and between approximately 12 W/mK, or may be between approximately 3 W/mK and between approximately 10 W/mK, or may be between approximately 5 W/mK and between approximately 8 W/mK. In some implementations, the thermal conductivity of the IMS substrate may be between approximately 2 W/mK and between approximately 4 W/mK. Accordingly, the second circuit board 18 may include a thermal conductivity of greater than 1 W/mK. The metallic base 142 of the metallic board 140 may assist in dissipating an increased amount of waste heat from the surface mount devices, as compared to the thermally conductive board 120, such as the more diffused FR4 board. Additionally, in contrast to the board 120, the metallic board 140 may allow for the direct interface of the heatsink 136 to the body of the board 140. Thermal grease 148 may be added to assist in the interfacing of the heatsink 136 to the body of the board 140, however, the heatsink 136 may interface with the body of the board 140 directly.

Referring still to FIG. 4B, similar to the board 120, the metallic board 140 may have a conductive layer 144 that may be formed of a solderable copper or other conductive, metallic or hybrid material. Additionally, the metallic board 140 may be overlaid with a dielectric insulation layer 146, positioned between the metallic base 142 and the conductive layer 144 on one of the opposing sides of the board 140. In some implementations, one side of the metallic board 140 may include the switching circuitry 22 soldered or attached to the singular conductive layer 144 while the opposing side of the board 140 may include the heatsink 136. However, other surface mounted devices may be contemplated disposed on the conductive layer 144 of the metallic board 140 including, but not limited to, gate drivers, snubbers, resonant load capacitors 150, rectifier bridges 72, and DC bus capacitors 84. Accordingly, in some implementations, the second circuit board 18 may be of a varying class of printed circuit boards that may define effective thermal conductivity and high-frequency performance, such as metallic or hybrid based boards including, but not limited to IMS boards, Aluminum Nitride (ALN) boards, and Active Metal Braided (AMB) boards.

Referring now to FIG. 3A and 5 - 8, the first circuit board 16 may include a first side 200 and a second side 202. Various devices including surface mounted devices and through-hole devices may be organized in a multitude of configurations on either the first side 200 or second side 202 of the first circuit board 16. In some implementations, the first side 200 of the first circuit board 16 may include a plurality of surface mounted devices including, but not limited to, DC bus capacitors 84 and resonant load capacitors 150, connectors or terminals 210 for the induction coil 14, and a socket or header for the controller 34, microcontroller, or processor that engages with the controller 34. Additionally, the first side 200 or the second side 202 of the first circuit board 16 may include, but is not limited to, the EMI filter 68, the rectifier 72, and the DC bus capacitor 84.

Referring to FIG. 3B and 5A-8B, the second circuit board 18 may include a first side 300 and a second side 302 defining a first edge 304 and a second edge 306. In some implementations, the first side 300 of the second circuit board 18 may include the switches 308 of the switching circuitry 22. Additionally, the heatsink 136 may be coupled to the second side 302 of the second circuit board 18 to assist in the dissipation of heat generated by the switches 308 of the switching circuitry 22. However, construction of the printed circuit board assembly may not necessitate the use of the heatsink 136.

Referring now to FIGS. 5A-8B, as discussed herein, the modular printed circuit board assembly of the induction cooktop 10 may comprise a variety of novel configurations and components, both structural and electrical, that provide for improved quality and performance, ease of manufacturing benefits, and cost savings. Though the induction cooktop 10 and the modular printed circuit board assembly described herein are discussed in reference to specific examples, various components and configurations of these assemblies may be implemented alone or in combination.

Referring to FIGS. 5A and 5B, in one exemplary implementation, the first circuit board 16 may extend along a first plane and the second circuit board 18 may extend along a second plane. The second circuit board 18 may be rigidly connected to the first circuit board 16 via connectors 310 as shown in FIG. 5A, or directly soldered to the first circuit board 16. When connected to the first circuit board 16, the first edge 304 of the second circuit board 18 may extend vertically from the second edge 206 of the first circuit board 16 and may be configured to be perpendicular to the first circuit board 16 and may be generally offset to the second edge 206 of the first circuit board 16. Accordingly, the modular printed circuit board assembly, illustrated in FIG. 5A and 5B, may generally form an L-shape. Additionally, the second circuit board 18 may at least partially extend over the second edge 206 of the first circuit board 16, and the second plane may be substantially orthogonal to the first plane.

The vertical configuration of the second circuit board 18 may be advantageous when limited width is allocated for the printed circuit board assembly of the induction cooktop 10, but a height configured to receive the modular printed circuit board assembly is available. Additionally, in the present configuration, the second circuit board 18 may be implemented without the heatsink 136 when low power induction cooktops 10 are used, such as those dissipating approximately 5W per device. As illustrated in FIG. 5A, the lack of the heatsink 136 assists in reducing the width of the modular printed circuit board assembly.

Referring now to FIG. 5B, the illustrated configuration of the modular printed circuit board assembly described above may include the heatsink 136. The heatsink 136 may be operably coupled to the second side 302 of the second circuit board 18 and may extend in a horizontal direction relative to the second side 302 of the second circuit board 18. Accordingly, due to the additional weight of the heatsink 136, on the second circuit board 18, the board 18 may be supported by a support member 312. The support member 312 may be coupled to the first side 200 of the first circuit board 16 and may extend outward relative to the first side 200 of the first circuit board 16 to engage a bottom surface 316. The bottom surface 316 partially includes the first edge 304 of the second circuit board 18 and the heatsink 136. The addition of the heatsink 136 to the illustrated configuration of the printed circuit board assembly may allow for the use of high-powered switching circuitry 22. In operation, as the switching circuitry 22 generates strong currents that may be conducted to the first circuit board 16, the switching circuit 22 may generate excess heat that may need to be managed. Accordingly, the heatsink 136 may be configured to effectively dissipate heat energy away from the switching circuitry 22 to assist maintaining operation of the switching circuitry 22, and to prevent damage to the induction cooktop 10.

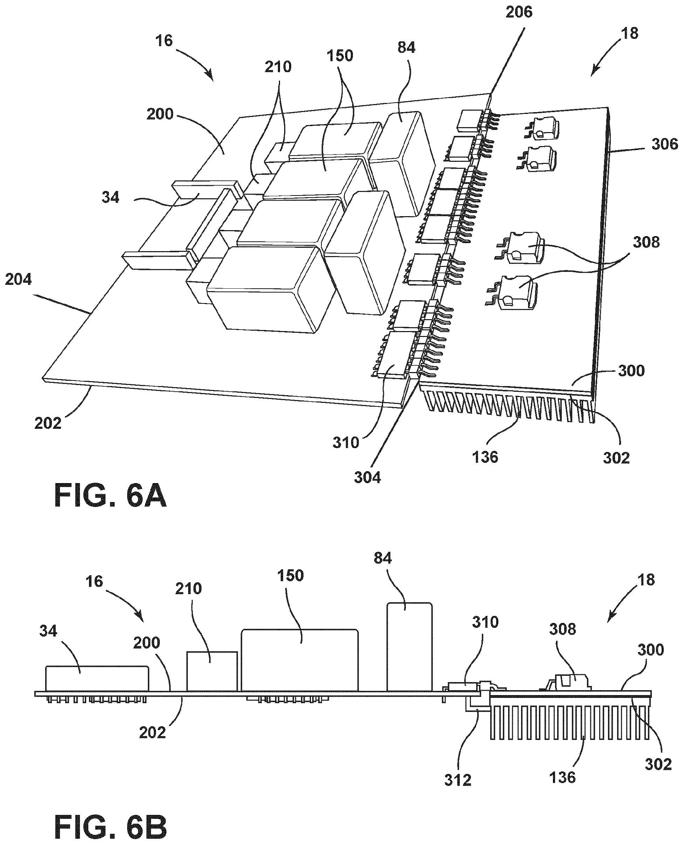

Referring now to FIGS. 6A and 6B, in another implementation, the first circuit board 16 extends along the first plane and the second circuit board 18 extends along the second plane, where the first plane is parallel to and spaced apart from the second plane. The second circuit board 18 may be rigidly connected to the first circuit board 16 via connectors 310, or directly soldered to the first circuit board 16. The second circuit board 18 may extend horizontally from the second edge 206 of the first circuit board 16 and may be positioned slightly below the second edge 206 of the first circuit board 16. The first side 300 of the second circuit board 18 may be facing upward relative to the first side 200 of the first circuit board 16, so that the first side 200 of the first circuit board 16 and the first side 300 of the second circuit board 18 may be facing the same direction. Accordingly, the substantially horizontal configuration of the second circuit board 18 is advantageous when height is limited within the induction cooktop 10.

The present implementation of the modular printed circuit board assembly, illustrated in FIGS. 6A and 6B, may include the heatsink 136 operably coupled to the second side 302 of the second circuit board 18. Similar to the implementation discussed relative to FIG. 5B, the additional weight of the heatsink 136 may necessitate the use of the support member 312. The support member 312 may be coupled to the second side 202 of the first circuit board 16 and may extend therefrom to engage the heatsink 136. Additionally, the heatsink 136 may extend in a downward direction opposite the switches 308 disposed on the first side 300 of the second circuit board 18.

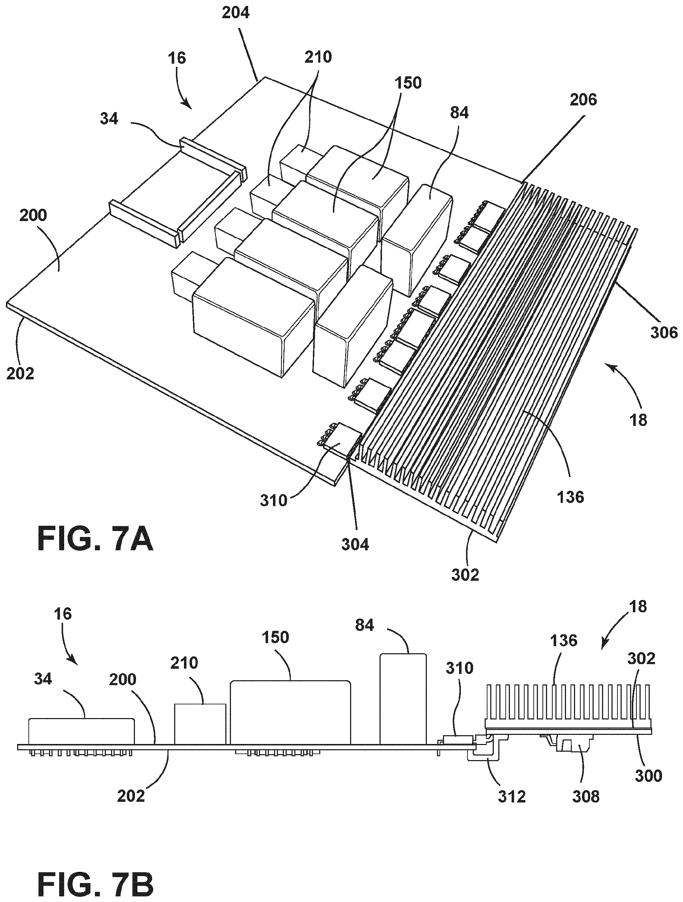

Similar to the configuration illustrated in FIGS. 6A and 6B above, in yet another implementation illustrated in FIGS. 7A and 7B, the first circuit board 16 may extend along the first plane and the second circuit board 18 extends along the second plane, where the first plane is parallel to and spaced apart from the second plane. The second circuit board 18 may be rigidly coupled to the first circuit board 16 via connectors 310, or the board 18 may be directly soldered to the first circuit board 16. The second circuit board 18 may extend horizontally from the second edge 206 of the first circuit board 16 and may be positioned slightly above the first side 200 of the first circuit board 16. Additionally, the second side 302 of the second circuit board 18 may be facing upward relative to the first side 200 of the first circuit board, so that the first side 200 of the first circuit board 16 and the second side 302 of the second circuit board 18 may be facing the same direction. The substantially horizontal configuration of the second circuit board 18 is advantageous when height is limited within the induction cooktop 10.

The present implementation of the printed circuit board assembly, illustrated in FIGS. 7A and 7B, may include the heatsink 136 operably coupled to the second side 302 of the second circuit board 18 and extending upward relative to a first side 200 of the first circuit board 16. As discussed herein, the additional weight of the heatsink 136 may necessitate the use of the support member 312. The support member 312 may be coupled to the second side 202 of the first circuit board 16 and may extend therefrom to engage the first side 300 of the second circuit board 18. Additionally, the heatsink 136 may extend in an upward direction opposite the switches 308 on the first side 300 of the second circuit board 18.

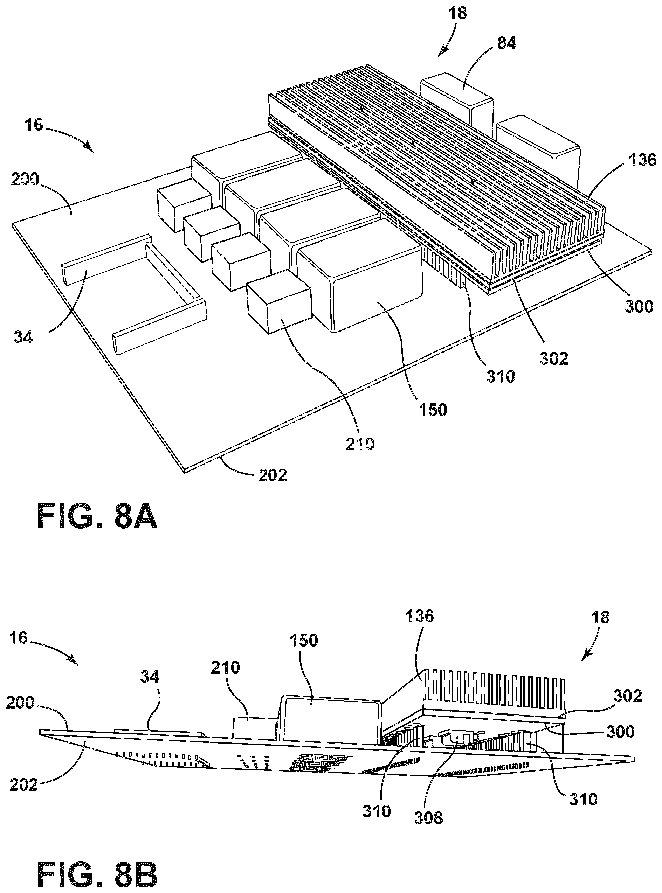

Referring now to FIGS. 8A and 8B, in yet another implementation, the first and second circuit boards 16, 18 may extend along the first and second planes, respectively. The first side 300 of the second circuit board 18 may include the switching circuitry 22 and the second side 302 of the second circuit board 18 may include the heatsink 136. The second circuit board 18 may be rigidly connected to the first side 200 of the first circuit board 16 via connectors 310, as shown in FIG. 8B. In some implementations, the switching circuitry 22 may be positioned between the various devices disposed on the first side 200 of the first circuit board 16. For example, the second circuit board 18 may be positioned between the DC bus capacitors 84 and resonant load capacitors 150 to reduce electromagnetic interference. Additionally, the switches 308 disposed on the first side 300 of the second circuit board 18 may face the first side 200 of the first circuit board 16. Accordingly, the heatsink 136 may be disposed on the second side 302 of the second circuit board 18, and may extend in an upward direction opposite the switches 308 on the first side 300 of the second circuit board 18. The configuration of the switches 308 and the heatsink 136, as illustrated in FIGS. 8A and 8B assist in dissipating the heat generated by the switches 308 when in operation.

The various configurations of the modular printed circuit board assembly and material substrates discussed herein may allow for optimized signal conduction between the first circuit board 16 and the second circuit board 18 within the induction cooktop 10. The transmission circuit 26 layers with power and ground signal routing in the first circuit board 16 enable reliable high-speed communication and control signals. Additionally, the simplified construction of the second circuit board 18 with fewer conductive layers but higher thermal conductivity may facilitate effective heat dissipation from the power electronic components mounted on it. The segregation of the first and second circuit boards 16, 18, combined with attributes like the dual substrate mounting surfaces of the second circuit board 18 may assist in saving valuable space within the compact induction cooktop 10. The efficient use of the first and second circuit boards 16, 18 and the ability to integrate additional components through surface-mount and embedded techniques may assist in achieving a highly integrated yet thermally managed design. Overall, the various configurations of the modular printed circuit board assembly may provide a synergistic solution that enhances signal integrity, thermal performance, and spatial optimization to assist in long-lasting operation of the induction cooktop 10.

It will be understood by one having ordinary skill in the art that construction of the described disclosure and other components is not limited to any specific material. Other exemplary embodiments of the disclosure disclosed herein may be formed from a wide variety of materials, unless described otherwise herein.

For purposes of this disclosure, the term "coupled" (in all of its forms, couple, coupling, coupled, etc.) generally means the joining of two components (electrical or mechanical) directly or indirectly to one another. Such joining may be stationary in nature or movable in nature. Such joining may be achieved with the two components (electrical or mechanical) and any additional intermediate members being integrally formed as a single unitary body with one another or with the two components. Such joining may be permanent in nature or may be removable or releasable in nature unless otherwise stated.

It is also important to note that the construction and arrangement of the elements of the disclosure as shown in the exemplary embodiments is illustrative only. Although only a few embodiments of the present innovations have been described in detail in this disclosure, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter recited. For example, elements shown as integrally formed may be constructed of multiple parts or elements shown as multiple parts may be integrally formed, the operation of the interfaces may be reversed or otherwise varied, the length or width of the structures and/or members or connector or other elements of the system may be varied, the nature or number of adjustment positions provided between the elements may be varied. It should be noted that the elements and/or assemblies of the system may be constructed from any of a wide variety of materials that provide sufficient strength or durability, in any of a wide variety of colors, textures, and combinations. Accordingly, all such modifications are intended to be included within the scope of the present innovations. Other substitutions, modifications, changes, and omissions may be made in the design, operating conditions, and arrangement of the desired and other exemplary embodiments without departing from the spirit of the present innovations.

It will be understood that any described processes or steps within described processes may be combined with other disclosed processes or steps to form structures within the scope of the present disclosure. The exemplary structures and processes disclosed herein are for illustrative purposes and are not to be construed as limiting.

## Claims

1. A circuit apparatus for an induction cooktop (10), comprising:
at least one induction coil (14);
at least one first circuit board (16) extending along a first plane;
at least one second circuit board (18) extending along a second plane and rigidly connected with the at least one first circuit board (16);
a power supply (36) disposed on the at least one first circuit board (16) and configured to supply power to the at least one induction coil (14);
a control circuit (20) disposed on the at least one first circuit board (16); and
switching circuitry (22) disposed on the at least one second circuit board (18) and electrically interposing the power supply (36) and control circuit (20) of the at least one first circuit board (16) and the at least one induction coil (14), wherein the switching circuitry (22) supplies power to the at least one induction coil (14).

2. The induction cooktop (10) of claim 1, wherein the switching circuitry (22) receives a control signal (Sc) from the control circuit (20) via the at least one first circuit board (16) and in response to the control signal (Sc) outputs power to the at least one induction coil (14).

3. The induction cooktop (10) of claim 2, wherein power from the switching circuitry (22) is conducted from the at least one second circuit board (18) to the at least one first circuit board (16).

4. The induction cooktop (10) of claim 1, wherein the first plane is coplanar with the second plane.

5. The induction cooktop (10) of claim 1, wherein the first plane is parallel to and spaced from the second plane.

6. The induction cooktop (10) of claim 1, wherein the at least one second circuit board (18) at least partially extends over the at least one first circuit board (16).

7. The induction cooktop (10) of claim 1, further comprising:
a heatsink (136) operably coupled to the at least one second circuit board (18), wherein the at least one second circuit board (18) includes a metallic board (140) defining a metallic base (142) configured to conduct heat, and wherein the switching circuitry (22) is positioned opposite the heatsink (136) on the metallic board (140) of the at least one second circuit board (18).

8. The induction cooktop (10) of claim 1, wherein the switching circuitry (22) includes at least one switch disposed on a first side (300) or a second side (302) of the at least one second circuit board (18), the first side (300) opposite the second side (302).

9. The induction cooktop (10) of claim 8, wherein the heatsink (136) is operably coupled to the first side (300) or the second side (302) of the at least one second circuit board (18) opposite the switching circuitry (22).

10. The induction cooktop (10) of claim 1, wherein the first circuit board (16) comprises a thermal conductivity of less than 1 W/mK, and the second circuit board (18) comprises a thermal conductivity of greater than 1 W/mK.

11. The induction cooktop (10) of claim 10, wherein the first circuit board (16) comprises a thermal conductivity of between 0.2 W/mK and 0.4 W/mK.

12. The induction cooktop (10) of claim 10, wherein the second circuit board (18) comprises a thermal conductivity of between 2 W/mK and 4 W/mK.

13. A method of manufacturing an induction cooktop (10), comprising:
providing at least one induction coil (14);
providing a control circuit (20) disposed on at least one first circuit board (16);
providing switching circuitry (22) disposed on at least one second circuit board (18);
outputting a control signal (Sc) from the control circuit (20) to the switching circuitry (22) via the at least one first circuit board (16);
outputting a drive signal (S_{D}) from the switching circuitry (22); and
conducting the drive signals (S_{D}) from the second circuit board (18) to the at least one induction coil (14).

14. The method of claim 13, wherein the switching circuitry (22) electrically interposes the control circuit (20) and the at least one induction coil (14).

15. The method of claim 13, further comprising:
providing power circuitry disposed on the at least one first circuit board (16) and configured to supply power to the at least one induction coil (14);
receiving the control signals (Sc) from the control circuit (20) via the at least one first circuit board (16) to the switching circuitry (22); and
outputting the drive signal (S_{D}) from the switching circuitry (22) in response to the control signal (Sc) via the at least one second circuit board (18) to the at least one first circuit board (16).
